(19) Europäisches Patentamt
European Patent Office
Office européen des brevets

(11) **EP 2 641 247 B1**

(12) **EUROPEAN PATENT SPECIFICATION**

(45) Date of publication and mention
of the grant of the patent:
**20.01.2016 Bulletin 2016/03**

(51) Int Cl.:
***G11C 11/16*** (2006.01)

(21) Application number: **11841445.7**

(22) Date of filing: **16.11.2011**

(86) International application number:
**PCT/US2011/061077**

(87) International publication number:
**WO 2012/068309 (24.05.2012 Gazette 2012/21)**

(54) **BIPOLAR SPIN-TRANSFER SWITCHING**

BIPOLARE SPINTRANSFER-SCHALTUNG

COMMUTATION BIPOLAIRE PAR TRANSFERT DE SPIN

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **17.11.2010 US 414724 P
04.03.2011 US 201113041104**

(43) Date of publication of application:
**25.09.2013 Bulletin 2013/39**

(73) Proprietor: **New York University
New York, NY 10016 (US)**

(72) Inventors:
• **KENT, Andrew
New York
New York 10012 (US)**

• **BEDAU, Daniel
New York
New York 10003 (US)**
• **LIU, Huanlong
New York
New York 10003 (US)**

(74) Representative: **Lawrence, John et al
Barker Brettell LLP
100 Hagley Road
Edgbaston
Birmingham B16 8QQ (GB)**

(56) References cited:
**EP-A1- 2 249 350        KR-A- 20100 089 860
US-A1- 2006 092 696      US-A1- 2008 151 614
US-A1- 2008 151 614      US-A1- 2009 296 462
US-A1- 2010 014 346      US-A1- 2010 195 380**

**Description**

CROSS-REFERENCE TO RELATED PATENT APPLICATIONS

This application claims priority from U.S. Provisional Application 61/414,724, filed 11/17/2010, and is a continuation-in-part of U.S. Application No. 13/041,104, filed 3/4/2011, which, is a divisional of U.S. Patent Application No. 12/490,588, filed June 24, 2009, which is a continuation-in-part of U.S. Patent Application No. 11/932,745, filed October 31, 2007, which is a continuation-in-part of U.S. Patent Application No. 11/498,303, filed August 1, 2006, which is a continuation-in-part of U.S. Patent Application No. 11/250,791, filed October 13, 2005, allowed November 14, 2006, and issued as U.S. Patent No. 7,170,778 on January 30, 2007, which is a continuation of U.S. Patent Application No. 10/643,762, filed August 19, 2003, allowed September 12, 2005, and issued as U.S. Patent No. 6,980,469 on December 27, 2005, all of which are incorporated herein by reference in their entirety.

FIELD OF THE INVENTION

The present invention generally relates to magnetic devices such as used for memory and information processing. More particularly the invention describes a spin-transfer torque magnetic random access memory (STT-MRAM) providing for bipolar spin-transfer switching.

BACKGROUND OF THE INVENTION

Magnetic devices that use a flow of spin-polarized electrons are of interest for magnetic memory and information processing applications. Such a device generally includes at least two ferromagnetic electrodes that are separated by a non-magnetic material, such as a metal or insulator. The thicknesses of the electrodes are typically in the range of 1 nm to 50 nm. If the non-magnetic material is a metal, then this type of device is known as a giant magnetoresistance or spin-valve device. The resistance of the device depends on the relative magnetization orientation of the magnetic electrodes, such as whether they are oriented parallel or anti-parallel (i.e., the magnetizations lie on parallel lines but point in opposite directions). One electrode typically has its magnetization pinned, i.e., it has a higher coercivity than the other electrode 50 and requires larger magnetic fields or spin-polarized currents to change the orientation of its magnetization. The second layer is known as the free electrode and its magnetization direction can be changed relative to the former. Information can be stored in the orientation of this second layer. For example, "1" or "0" can be represented by anti-parallel alignment of the layers and "0" or "1" by parallel alignment. The device resistance will be different for these two states and thus the device resistance can be used to distinguish "1" from "0." An important feature of such a device is that it is a non- volatile memory, since the device maintains the information even tens of nanometers when the power is off, like a magnetic hard drive. The magnet electrodes can be sub-micron in lateral size and the magnetization direction can still be stable with respect to thermal fluctuations.

In conventional magnetic random access memory (MRAM) designs, magnetic fields are used to switch the magnetization direction of the free electrode. These magnetic fields are produced using current carrying wires near the magnetic electrodes. The wires must be small in cross-section because memory devices consist of dense arrays of MRAM cells. As the magnetic fields from the wires generate long-range magnetic fields (magnetic fields decay only as the inverse of the distance from the center of the wire) there will be cross-talk between elements of the arrays, and one device will experience the magnetic fields from the other devices. This cross-talk will limit the density of the memory and/or cause errors in memory operations. Further, the magnetic fields generated by such wires are limited to about 0.1 Tesla at the position of the electrodes, which leads to slow device operation. Importantly, conventional memory designs also use stochastic (random) processes or fluctuating fields to initiate the switching events, which is inherently slow and unreliable (see, for example, R. H. Koch et al., Phys. Rev. Lett. 84, 5419(2000)).

In U.S. Pat. No. 5,695,864 and several other publications (e.g., J. Slonckewski, Journal of Magnetism and Magnetic Materials 159, LI (1996)), John Slonckewski described a mechanism by which a spin-polarized current can be used to directly change the magnetic orientation of a magnetic electrode. In the proposed mechanism, the spin angular momentum of the flowing electrons interacts directly with the background magnetization of a magnetic region. The moving electrons transfer a portion of their spin-angular momentum to the background magnetization and produce a torque on the magnetization in this region. This torque can alter the direction of magnetization of this region and switch its magnetization direction. Further, this interaction is local, since it only acts on regions through which the current flows. However, the proposed mechanism was purely theoretical.

Spin-transfer torque magnetic random access memory (STT-MRAM) devices hold great promise as a universal memory. STT-MRAM is non-volatile, has a small cell size, high endurance and may match the speed of static RAM (SRAM). A disadvantage of the common collinearly magnetized STT-MRAM devices is that they often have long mean switching times and broad switching time distributions. This is associated with the fact that the spin-torque is non-zero only when the layer magnetizations are misaligned. Spin transfer switching thus requires an initial misalignment of the switchable magnetic (free) layer, e.g. from a thermal fluctuation. Relying on thermal fluctuations leads to incoherent reversal with an unpredictable incubation delay, which can be several nanoseconds.

Spin-transfer torque magnetic random access memory (STT-MRAM) devices use current or voltage pulses to change the magnetic state of an element to write information. In all STT-MRAM devices known to date, voltage/current pulses of *both* positive and negative polarities are needed for device operation. For example, positive pulses are needed to write a "1" and negative polarity pulses are needed to write a "0". (Of course, the definition of which magnetic state represents a "1" and which a "0" is arbitrary.) This magnetic element typically has two possible states, magnetization oriented either "left" or "right", parallel or antiparallel to the magnetization of a reference layer in the device. These two magnetic states have different resistances, which can be used to read-out the information electrically.

Using present complementary metal-oxide-semiconductor (CMOS) technology, circuitry is needed to control the signals to STT-MRAM cells. Prior STT-MRAM devices required bipolar sources and the bit cells were set to one state by one polarity and the other state by the other polarity, i.e. unipolar That is, the source needed to be able to provide both polarities because each polarity only could write either "0" or "1". Although reading can be done with a unipolar voltage/current source, writing information required a bipolar source.

US 2010/0195380 discloses a STRAM memory cell, in which a selected resistive state is written to a magnetic tunneling structure (MTS) by applying a succession of indeterminate write pulses thereto until the selected resistive state is verified. The MTS comprises a spin polarizer layer, a free layer having soft magnetic properties and a reference layer.

US 2009/0296462 discloses a magnetic device comprising a reference magnetic layer with a fixed magnetic helicity and/or magnetization direction and a free magnetic layer with a changeable magnetic helicity and/or magnetization direction, the fixed and free layers separated by a non-magnetic layer.

US 2006/0092696 discloses a storage element composed of a storage layer for holding information with the magnetization of a magnetic material, a magnetization fixed layer provided relative to the storage layer through an intermediate layer, the magnetization of the storage layer being changed with application of an electric current to the laminated layer direction.

SUMMARY OF THE INVENTION

In view of the limitations associated with conventional designs of devices using spin transfer torque, an object of the present invention is to provide a structure and methods that provide an improved magnetic memory or magnetic information processing device.

It is another object of the invention to produce a magnetic device requiring simplified external drive circuitry.

It is another object of the invention to produce a magnetic device that has advantages in terms of speed of operation.

It is another object of the invention to produce a magnetic device that has advantages in terms of reliability.

It is another object of the invention to produce a magnetic device that consumes less power.

These and other additional objects of the invention are accomplished by a device and methods that employ magnetic layers in which the layer magnetization directions do not lie along the same axis. For instance, in one embodiment, two magnetic regions have magnetizations that are orthogonal.

In accordance with the invention there is provided a magnetic device and memory array as defined by the appended claims.

Disclosed herein is a magnetic device that does not require a specific polarity of pulse. The magnetic device has at least a first stable state and a second stable state. The application of a pulse of appropriate amplitude and duration will switch the magnetic device from whatever its current state is to the other state, i.e. from the first state to the second state or the second state to the first state. Thus, the pulse source need only be unipolar and the bit cell is bipolar in that it can accept a pulse of either polarity.

BRIEF DESCRIPTION OF THE DRAWINGS

The forgoing and other features of the present invention will be more readily apparent from the following detailed description and drawings of the illustrative embodiments of the invention wherein like reference numbers refer to similar elements through the views and in which:

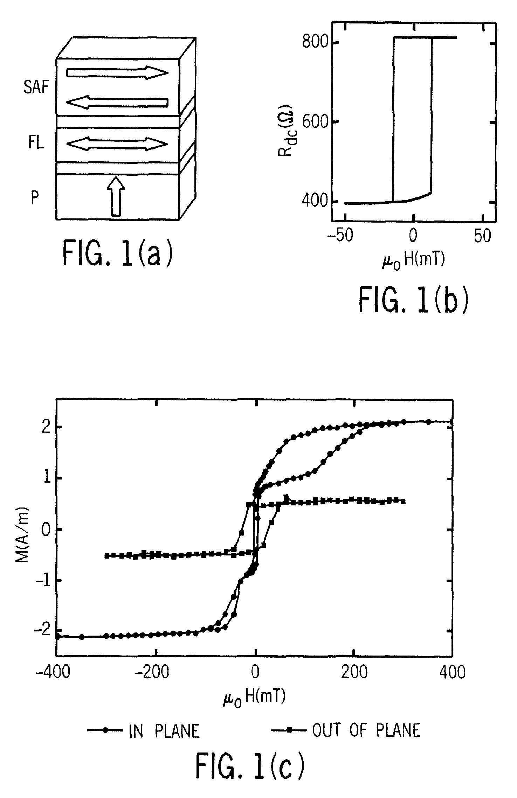

Figure 1(a) illustrates a OST-MRAM layer stack, Fig. 1(b) is a graph of device resistance vs. in-plane field showing 107% magnetoresistance (MR) and the switching of the free layer from the parallel (P) to antiparallel (AP) state at 12 mT and AP to P state at -16 mT. 1; Fig. 1(c) is a graph of device vibrating sample magnetometry (VSM) measurements of the magnetization of the layer stack wherein the dotted line curve shows the switching of the free layer and (synthetic anti-ferramagnetic) (SAF) free layer under an in-plane applied field and the squared line red curve shows the characteristics of the polarizing layer, under a field perpendicular to the plane, demonstrating the high remanence and a coercive field of 50 mT;

Figure 2 is an example of precessional switching and illustrates a pulse for producing magnetization precession;

Figure 3 is a graph of the switching probability from the P to the AP state as a function of pulse duration for three different pulse amplitudes at an applied field of 10 mT. 100% switching probability is achieved for pulses of less than 500 ps duration;

Figures 4(a) and 4(b) are graphs of switching probability as a function of pulse amplitude at a fixed pulse duration of 700 ps with Fig. 4(a) P to AP state; and Fig. 4(b) AP to P state wherein the switching is bipolar, occurring for both positive and negative pulse polarities;

Figure 5 is an example of direct switching and shows a voltage trace of a bit cell switching event;

Figures 6(a)-6(f) illustrate the statistical probability from P to AP as a function of the pulse amplitude; larger pulse amplitudes produce shorter switching start times and shorter times to switch;

Figures 7(a)-7(c) illustrate typical device characteristics for a 50 nm x 115 nm ellipse shaped bit cell; the resistance is measured as a function of applied in-plane magnetic field; Fig. 7(a) shows the applied field induced switching of the reference and free layers; Fig. 7(b) shows the applied field induced switching of just the reference layer and Fig. 7(c) shows the applied field induced switching of just the free layer;

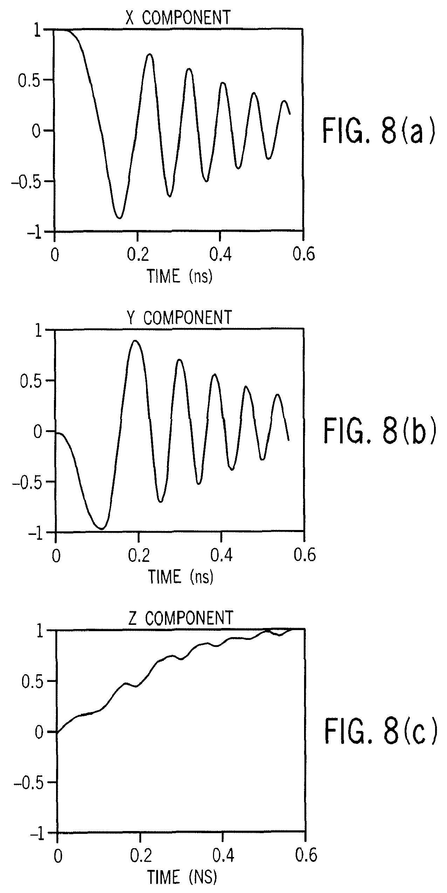

Figures 8(a)-8(c) show for conditions ($\beta$=1, $a_J$=+0.025) the magnetization switching is precessional, starting at time zero from a P state; the three components of the magnetization are show, $m_x$, my and $m_z$;

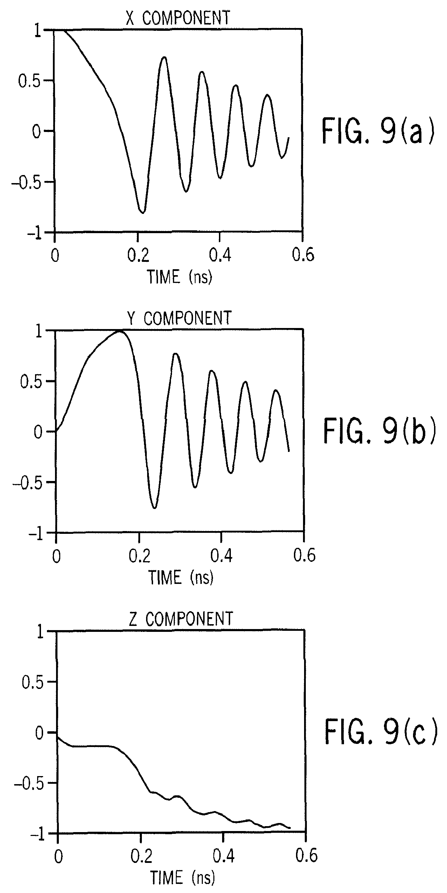

Figures 9(a)-9(c) show for conditions ($\beta$=1, $a_J$=-0.025) the magnetization switching is precessional, this shows that both positive and negative polarity pulses lead to precessional magnetization reversal, with somewhat different rates (or frequencies) of precession;

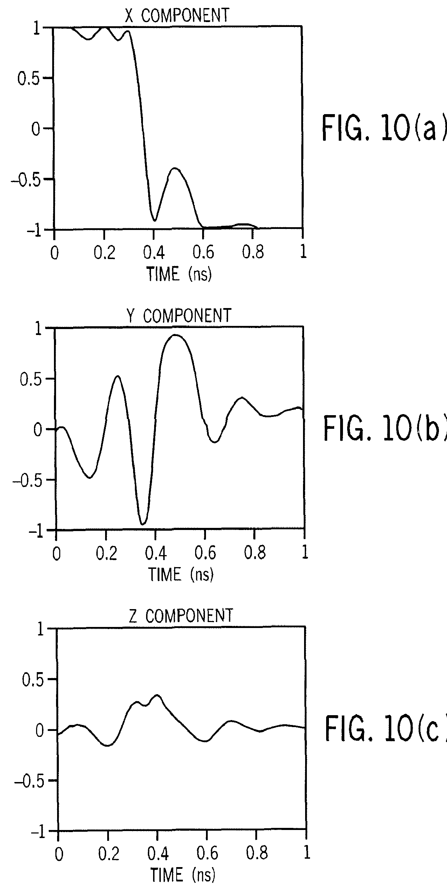

Figure 10(a)-10(c) show for conditions ($\beta$=5, $a_J$=+0.008) the magnetization switching from P to AP is direct (i.e. there is no precession);

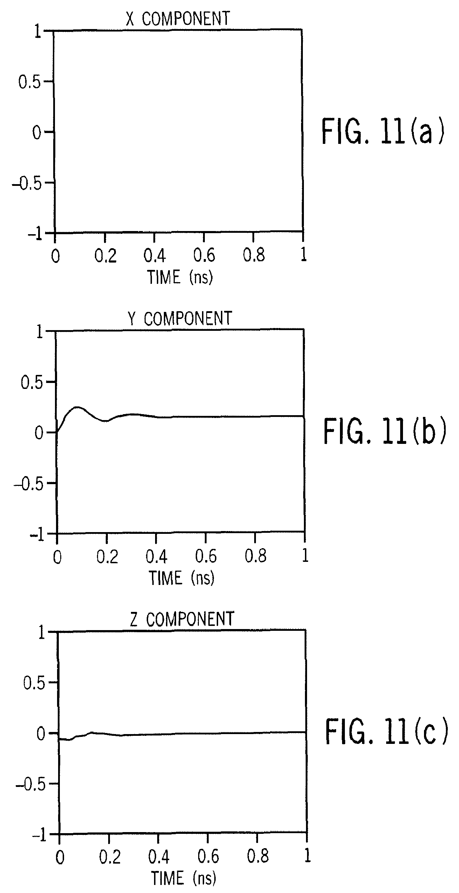

Figures 11(a)-11(c) show for conditions ($\beta$=5, $a_J$=-0.008) there is no switching from the P state; only a positive pulse (Fig. 10(a)-10(c)) leads to magnetization switching from the P to the AP state;

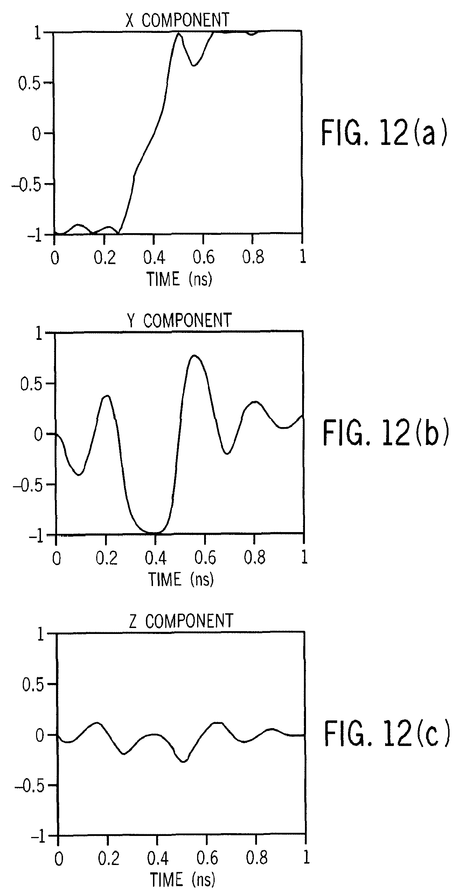

Figures 12(a)-12(c) show for conditions ($\beta$=5, $a_J$=-0.006, i.e. negative pulse polarities) there is direct switching from the AP to P state; and

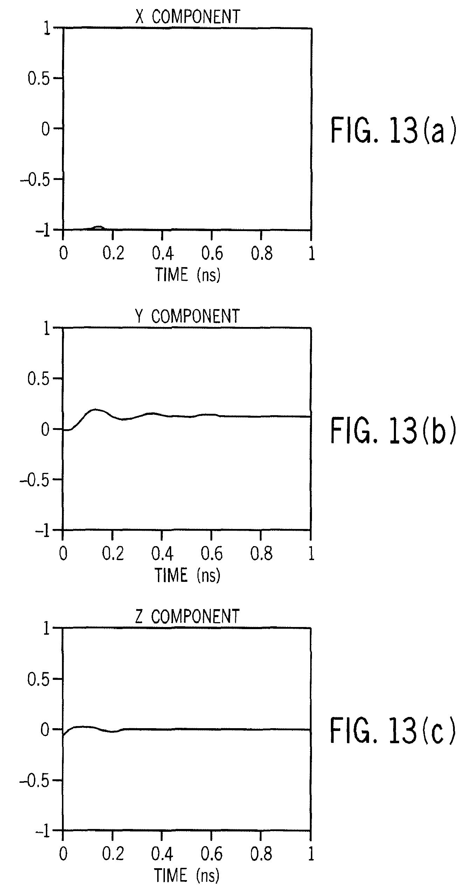

Figures 13(a)-13(c) show for conditions ($\beta$=5, $a_J$=+0.006, i.e. positive pulse polarities) there is no switching from the AP to P state, switching from the AP to P state only occurs for negative pulse polarities (Fig. 12(a)-12(c)).

## DETAILED DESCRIPTION OF THE PREFERRED EMBODIMENTS

The present invention is directed to orthogonal spin transfer MRAM (OST-MRAM) devices and methods. OST-MRAM employs a spin-polarizing layer magnetized perpendicularly to a free layer to achieve large initial spin-transfer torques. This geometry has significant advantages over collinear magnetized STT-MRAM devices as it eliminates the nanosecond incubation delay and reduces the stochastic nature of the switching. It also has the potential for write times below 50 ps. Fig. 1(a) illustrates one embodiment of a STT-MRAM. A perpendicularly magnetized polarizer (P) is separated by a non-magnetic metal from the free magnetic layer (FL). The free layer forms one electrode of a MTJ. The other electrode, the reference layer, consists of an SAF free layer.

In OST-MRAM the reference magnetic layer is used to read out the magnetic state. The magnetization of this layer is set to be collinear to that of the free layer and the memory states correspond to the free layer magnetization parallel (P) or antiparallel (AP) to the reference layer magnetization. Previous OST-MRAM devices utilized an out-of-plane magnetized spin-polarizer was combined with an in-plane magnetized spin-valve. While fast switching was seen, the resulting read-out signals were small; there was less than ~ 5% magnetoresistance (MR). The device impedance was also small,- 5 $\Omega$.

One embodiment of the present invention is directed to a magnetic tunnel junction (MTJ) based OST-MRAM device that combines fast switching and large (> 100%) MR, both of which are critical for applications. The device impedance is ~ 1 k $\Omega$ and thus compatible with complementary metal-oxide-semiconductor (CMOS) field effect transistor (FET) memory control circuitry. The write function switches the state of the cell, rather than setting the state. Further, the switching is bipolar, occurring for positive and negative polarity pulses, consistent with a precessional reversal mechanism.

In one embodiment, the present invention provides apparatus and methods enabling a "toggle" mode of spin-transfer device operation. The pulse source may be unipolar because the bit cell does not set the state based upon the polarity of the pulse, i.e. it is bipolar. Rather a pulse of sufficient amplitude for either polarity will "toggle" the magnetic state of the device, "1"→"0" and "0"→"1". Thus, a pulse (of sufficient time and amplitude) will change the magnetic state of the device or bit cell, irrespective of the original magnetic state. As such, in one embodiment, the writing of information in such a "toggle" mode of operation may require reading the device or bit cell initial state and either applying or not applying a current/voltage pulse depending on the information to be written. That is, if the device or bit cell was already in the desired state no pulse would be applied.

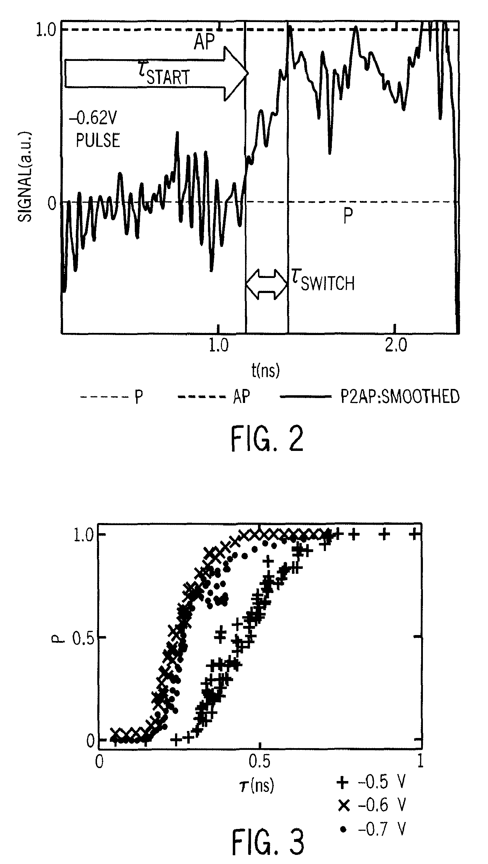

As an example of this embodiment, FIG. 2 illustrates an experimental time resolved voltage trace of a bit cell switching event. A voltage pulse of -0.62 V is applied for about 2 ns, starting at time zero in the plot. The device is a 50 nm x 115 nm ellipse shaped bit cell and has an impedance of about 2 kOhm. The horizontal dashed trace at the signal level of 1 corresponds to the antiparallel state (AP). The horizontal dashed trace at signal level 0 shows the response when the bit cell is in the parallel (P) state. (P and AP refer to the magnetization direction of the free layer with respect to the reference layer magnetization in the stack.) At about 1.1 ns the device switches from the P to the AP state. The device then precesses at a frequency of about 3 GHz. The device final state (P or AP) depends in the pulse duration.

The use of a bipolar toggle for STT-MRAM allows the external drive circuitry to be simplified because all device operations (i.e., reading and writing) can be accomplished with a power source of one polarity. In addition, it is believed that devices utilizing the present invention will likely operate faster because pulses of less than 500 psec will toggle the magnetic state of the device. An additional benefit of the need for only one polarity is that power consumption will be reduced. This is due, in part, to the fact that the supply voltages to the device do not need to be switched between different levels. In present MRAM-CMOS designs, typically one transistor is associated with each MRAM bit cell and the source and drain voltages on this transistor need to be varied to write the information. In accordance with one embodiment of the present invention, the source or drain voltages may be maintained at constant levels. Maintaining the source or drain voltages at a constant level(s) reduces the power required for device operation, as each time the polarity of a supply voltage is changed energy is required. In one embodiment, switching requires an energy of less than 450 fJ in a free magnetic layer that is thermally stable at room temperature.

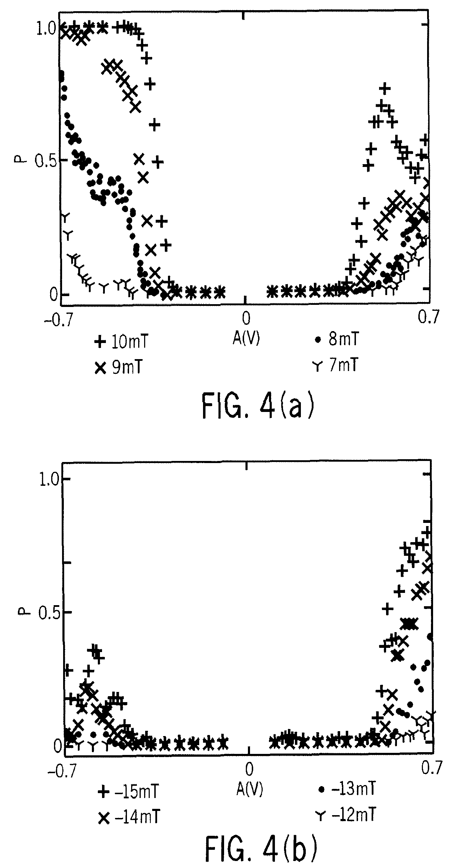

As previously mentioned hereinbefore, one characteristic of the described OST-MRAM devices is that the switching is bipolar, i.e. a bit cell in accordance with the present invention may be switched between states using either voltage pulse polarity. However, there can be thresholds for the pulse to trigger a switch. Those thresholds may differ depending on the pulse, for example depending on the pulse polarity or depending on the device initial state, i.e. P or AP. This characteristic is illustrated further below regarding the examples in Figures 4(a) and 4(b).

This asymmetry in the probability distribution for the two polarities is distinct from the characteristics seen in common collinear free layer/tunnel barrier/SAF type STT devices. In these devices switching only occurs for one polarity of the voltage pulse, or through thermally induced backhopping. As previously stated, in OST-MRAM devices switching occurs for both polarities. This bipolar switching process is an indication that the torque originates from the perpendicular polarizer. For a collinear device we would expect $P \rightarrow AP$ switching only for positive polarity pulses, based on spin-transfer torque models. For one embodiment of the invention, a positive polarity pulse leads to a lower switching probability (Figure 4(a)) compared to the opposite polarity pulse. If the switching processes involved simple heating of the junction, rather than the spin-transfer torque switching in the OST-MRAM device as described herein, it would be expected that a symmetric switching probability distribution and a monotonic dependence of the switching probability on pulse amplitude would be observed, which is not the case as seen in Figures 4(a) and 4(b).

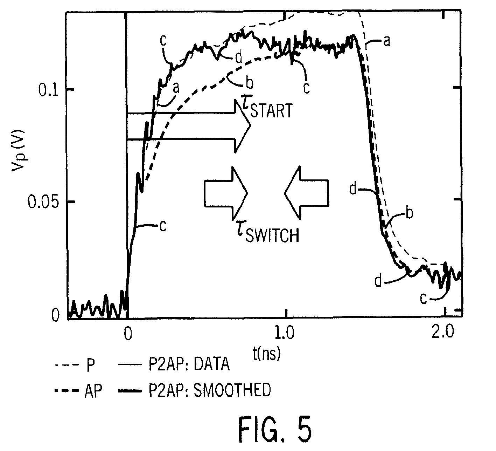

As an example of this embodiment, FIG. 5 illustrates an experimental time resolved voltage trace of a bit cell switching event. A voltage pulse of 0.7 V is applied for about 2 ns, starting at time zero in the plot. The device is a 60 x 180 nm$^2$ shaped hexagon and has an impedance of order of 1 kOhm. The dotted line trace "a" shows the response when the bit cell is in the parallel state (P). The line trace "b" shows the response when the bit cell is in the antiparallel (AP) state. (P and AP refer the magnetization direction of the free layer with respect to the reference layer magnetization in the stack.) The line trace "c" shows an event in which the device switches from P to AP about 1.2 ns after the start of the pulse. The line trace "d" shows the same data filtered to remove the high frequency components, which is associated with noise. The start time and switching time are defined as indicated in this FIG. 5.

The free layer magnetization rotation about its demagnetizing field will result in a switching probability that is a nonmonotonic function of the pulse amplitude or duration, because if the pulse ends after the free layer magnetization finishes a full rotation (i.e., a $2\pi$ rotation), the probability of switching will be reduced. The precession frequency can also be a function of the pulse polarity due to the fringe fields from the polarizing and reference layers. Further, spin-torques from the reference layer break the symmetry of the reversal by adding torques that favor one free layer state over another.

Thus, a device in accordance with the principles of the present invention can utilize voltage/current pulses of just one polarity to write both "0" and "1" states. A device initially in the "1" state can be switched to a "0" state and a device originally in the state "0" can be switched into the state "1" with the same polarity pulse. Further, although the pulse amplitudes needed for these operations can differ (see Figs. 4(a) and 4(b)), this aspect can be used to advantage in device operation. For example, if the thresholds differ then the pulse amplitude can uniquely determine the device final state. In one embodiment, the differences between the thresholds for a positive polarity pulse and a negative polarity pulse can be significant enough that a read step would be unnecessary. For example, where a negative pulse requires a much lower amplitude and or pulse duration to achieve a 100% probability of a switch from P to AP than the positive pulse and vice versa, the positive pulse requires a much lower amplitude or pulse duration to achieve 100% probability of a switch from AP to P, those thresholds can be utilized to achieve a desired functionality. If the positive pulse that is necessary to switch from AP to P would be below the threshold necessary to switch from P to AP and vice versa for the negative pulse, then a device need not read the bit cell prior to a write. For example, where a write of the bit cell to P state is desired, the device can be pulsed with a sufficient (above the 100% threshold for switching to P but below that threshold for a switch to AP) positive pulse. If the bit cell is in AP, the positive pulse is sufficient to switch to P. However, if the bit cell is already in P, the positive pulse would be insufficient (i.e. below the threshold) to switch to AP.

The following non-limiting Examples illustrate various attributes of the invention.

Example 1

The OST-MRAM layer stack was grown on 150 mm oxidized silicon wafers using a Singulus TIMARIS PVD module. The device layer structure is illustrated in Fig. 1(a). The polarizer consists of a Co/Pd multilayer exchange coupled to a Co/Ni multilayer. The Co/Ni multilayer has a high spin polarization due to the strong spin-scattering asymmetry of Co in Ni and a perpendicular magnetic anisotropy (PMA). To enhance the layer coercivity and remanence this layer is coupled to Co/Pd which has a very large PMA but a lower spin polarization due to the strong spin-orbit scattering by Pd. The polarizer is separated by 10 nm of Cu from an in-plane magnetized CoFeB free layer that is one of the electrodes of a MTJ. The MTJ structure is 3 CoFeB|0.8 MgO|2.3 $Co_{0.4}$ $Fe_{0.4}B_{0.2}$|0.6 Ru|2 $Co_{0.4}$ $Fe_{0.3}$ 16 PtMn (number to the left of each composition indicates the layer thicknesses in nm). The wafer was annealed at 300° C for 2 hours in a magnetic field and then characterized by vibrating sample magnetometry (VSM), ferromagnetic resonance spectroscopy (FMR), and current-in-plane-tunneling (CIPT) measurements. Fig. 1(c) shows VSM measurements of the film magnetization for in-plane and perpendicular-to-the-plane applied fields. The free layer is very soft while the reference layer has a coercive field of about 50 mT; the exchange bias from the antiferromagnetic PtMn is 100 mT. The perpendicular polarizer has a coercive field of 50 mT.

The wafers were patterned to create OST-MRAM devices using e-beam and optical lithography. Ion-milling was used to etch sub-100 nm features through the free layer. Device sizes varied from 40 nm x 80 nm to 80 nm x 240 nm in the form of rectangles, ellipses and hexagons. Approximately 100 junctions were studied. Set forth in greater detail below are results obtained on one 60 nm x 180 nm hexagon shaped device. Although not presented here, similar results have been obtained on other devices of this type.

The sample resistance was measured by applying a small voltage ($V_{dc}$, = 30 mV) and measuring the current. The MR of the device is mainly determined by the relative orientation of the free (3 CoFeB) and reference (2.3 CoFeB) layers, which can be either parallel (PA) or antiparallel (AP). Figure 1(b) shows the minor hysteresis loop of the free layer. The patterned free layer has a coercive field of 14 mT at room temperature and the device has 107% MR. The loop is centered at about -2 mT, due to a small residual dipolar coupling from the synthetic antiferromagnetic (SAF) reference layer.

To measure the current-induced switching probability, pulses of variable amplitude, duration and polarity were applied. An applied field was used to set the sample into the bistable region (see Fig. 1(b)) and then voltage pulses were applied, using a pulse generator that provides up to 2 V amplitude with a minimum pulse duration of 50 ps. By measuring the resistance using a small dc voltage before and after the pulse, we can determine the device state. Since the free layer is very stable without any applied voltage (see the discussion below), it can be assumed that a switching event (i.e., dynamics of the free layer magnetization to a point at which the free layer magnetization would reverse in the absence of the pulse) occurred during the voltage pulse. In this setup, positive voltage is defined to correspond to electrons flowing from the bottom to the top of the layer stack, i.e. from the polarizer toward the free and reference layers.

Both amplitude and pulse duration where observed to impact the probability of a switching event. Figures 3 shows the switching probability from the P to the AP state as a function of pulse duration in an applied field of 10 mT for three different pulse amplitudes, -0.5, -0.6 and -0.7 V. Higher amplitude pulses lead to switching at shorter pulse durations. It has been observed that a device in accordance with the present invention can be switched with pulses less than 500 ps in duration with 100% probability. The energy needed for 100% probability switching is less than 450 fJ. As 100% switching probability was observed for pulses as short as 500 ps, it is believed that there is no incubation delay of several nanoseconds as observed in conventional collinear or nearly collinearly magnetized devices. The switching process of the present invention thus provides both fast and predictable results.

To determine the energy barrier of the reversal, the coercive field of the sample is measured at different field sweep rates. The energy barrier is then determined from the relation:

$$\tau = \tau_0 \exp\left[\xi_0\left(1 - \frac{H_{app}}{H_c}\right)^{\beta}\right], \qquad (1)$$

where $\xi_0$ = $U_0/kT$, the zero applied field energy barrier over the thermal energy, with T = 300 K. Assuming $\beta$ = 2, we

obtain an energy barrier of $\xi = 40$ at $\mu_0 H_{app} = 0.01$ T, indicating the layer is very thermally stable at room temperature.

As previously mentioned, one characteristic of the described OST-MRAM devices is that the switching is bipolar, i.e. a bit cell in accordance with the present invention may be switched between states using either voltage pulse polarity. For the examples described above, Figure 4(a) shows the switching probability versus pulse amplitude for (a) P → AP switching and Figure 4(b) shows AP → P switching at a pulse duration of 700 ps. Although the OST-MRAM device is bipolar, it can be seen in Figure 4(a) that negative polarity pulses lead to higher switching probability than positive polarity pulses. The opposite is found in Figure 4(b) for AP → P. In both cases applied fields closer to the coercive field lead to a lower voltage pulse threshold for switching. Also the switching probability is a nonmonotonic function of the pulse amplitude. The observed data is qualitatively consistent with precessional reversal being driven by the perpendicular polarizer.

### Example 2

The magnetization dynamics of the device and method in the preferred embodiment can be modeled to a first approximation by considering the spin transfer torques associated with the perpendicular polarizer and the reference layer as follows:

$$\frac{d\hat{m}}{dt} = -\gamma\mu_0\hat{m} \times \vec{H}_{\text{eff}} + \alpha\hat{m} \times \frac{d\hat{m}}{dt} + \gamma a_J\hat{m} \times (\hat{m} \times \hat{m}_P) - \beta\gamma a_J\hat{m} \times (\hat{m} \times \hat{m}_R)$$

$$(2)$$

where $m$ represents the magnetization direction of the free layer (it is a unit vector in the direction of the free layer magnetization). $\alpha$ is the damping parameter of the free layer. The prefactor, $a_J$, depends on the current density $J$, the spin-polarization $P$ of the current density $J$, and the cosine of the angle between the free and pinned magnetic layers, $\cos(\theta)$, such that $a_J = \hbar Jg(P,\cos(\theta))/(eMt)$. The $\hbar$ is the reduced Planck's constant, $g$ is a function of the spin-polarization $P$ and $\cos(\theta)$, $M$ is the magnetization density of the free layer, $e$ is the charge of an electron, and $t$ is the thickness of the free layer. The last two terms are the spin transfer from the perpendicular polarizer ($m_P$) and the in-plane magnetized reference layer ($m_R$). The $\beta$ (beta) represents the ratio of the magnitude of these two torques.

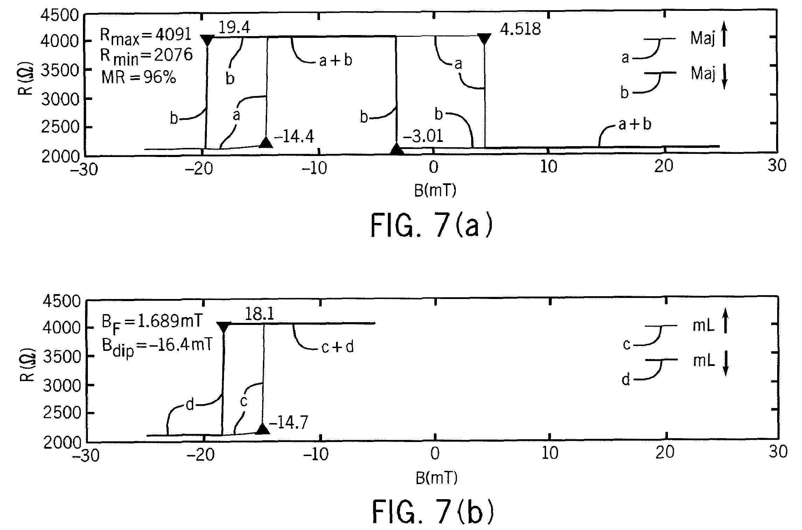

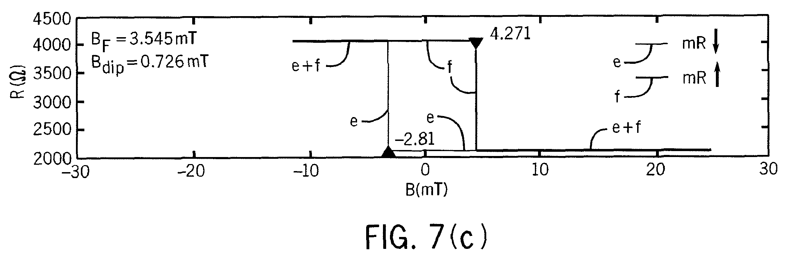

Analysis of this equation shows that the ratio $\beta$ (beta) is important in controlling the magnetization dynamics. Higher $\beta$ (greater than 1) results in a range of current pulse amplitudes in which the switching is directly from P to AP for one current polarity and AP to P for the other current polarity. For higher current amplitudes the switching is precessional (toggling from AP to P to AP and continuing, as shown experimentally in Figure 2). The switching is bipolar in this case, occurring for both current polarities. The device impedance is about 2-4 k Ohms as shown in Figs. 7(a)-7(c).

For small beta (beta less than or about equal to 1) the range of current pulse amplitudes in which direct switching occurs is reduced. The motion for small $\beta$ becomes precessional (toggling from AP to P to AP and continuing, as was seen in experiments shown in Figure 2). When the magnetization motion is precessional higher current amplitudes generally result in higher precession frequencies.

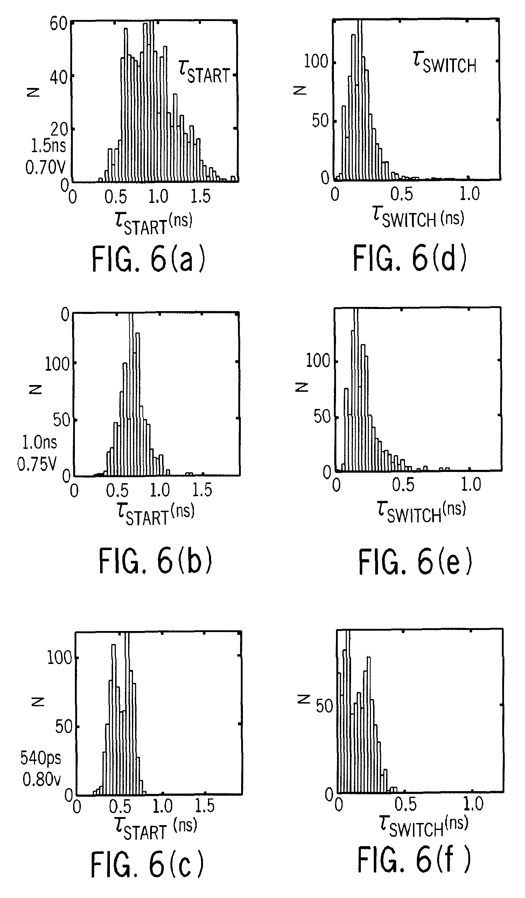

The presence of the polarizer (in all cases cited above) reduces the time needed to set the bit cell state (see Figures 6(a)-6(f)) improving device performance, both reducing the switching time and reducing the current (or voltage) amplitude needed for switching.

Calculations of the switching dynamics based on model described in Eqn. (2) above show the type of characteristics that can be found in OST-MRAM stacks. The behavior was determined for a thin film nanomagnet with in-plane anisotropy field (along x) of 0.05 T, damping ($\alpha = 0.01$), magnetization density of $\mu M_s = 0.5T$ and the magnetization of the reference layer in the +x direction.

### Example 3

In certain embodiments the reliable writing in which pulse duration is not critical. In such a case, for a memory operation, it may be preferable that the pulse duration not be a critical variable (i.e. the precise pulse duration would not determine the bit cell final state; only the pulse polarity--positive or negative-would be important. In this case, the device is provided with $\beta$ about equal to or greater than 1. This can be accomplished in a number of ways:

The spin-polarization from the reference layer can be increased by choice of materials for the magnetic tunnel junction and reference layer. For example, CoFeB in contact with MgO has a large spin-polarization. Permalloy (NiFe) in contact with MgO has a lower spin polarization.

The spin-polarization from the polarizing layer can be reduced. This can be accomplished in a number of ways, for example, without limitation:

a. Choice of materials for the composition of the polarizing layer: Co/Ni multilayers have a large spin-polarization. However, Co/Pd or Co/Pt have a much lower spin-polarization. A composite polarizing layer can have an adjustable polarization. For example a multilayer of Co/Ni on Co/Pd or Co/Pt in which the thickness of the Co/Ni is varied (from, say 0.5 to 5 nm) is a means to control the current spin-polarization from the polarizing layer, where the Co/Ni is the layer in closer proximity to the free magnetic layer. A thin layer with large spin-orbit coupling, such as Pt or Pd, could also be placed on the surface of the polarizing layer closer to the free magnetic layer. This would also serve to reduce the current spin-polarization.

b. Alternatively, the nonmagnetic layer between the polarizer and the free layer can be varied to control the spin-polarization of carriers from the polarizing layer (and thus the parameter $\beta$). If this layer has a short spin-diffusion length the polarization would be reduced. Including defects in Cu can reduce its spin-polarization (e.g., Ni in Cu or other elements). The Cu can also be an alloy with another element, such as Zn or Ge. There are many possible material combinations that would reduce the spin-polarization from the polarizing layer.

For fast low energy switching it would be preferable to not increase $\beta$ far beyond 10, because the torque from the perpendicular polarizer sets the switching time and thus the energy required to switch the device (as discussed above).

For fastest write operation: $\beta$ preferably should be less than one, and the pulse timing needs to a very well-controlled variable. The switching is bipolar and only a single polarity voltage source is needed for device write operations, potentially simplifying the drive circuitry.

Analysis of the model described above (see section [0043]) also shows that the threshold voltage and current for switching can be reduced through a number of means. First, the free layer magnetization density or free layer thickness can be reduced. However, this also is expected to reduce the bit cell stability. So the magnetization density or free layer thickness cannot be made arbitrarily small. Second, the free layer can have a component of perpendicular magnetic anisotropy. This anisotropy would be insufficient in and of itself to reorient the magnetization perpendicular to the layer plane, but would nonetheless be effective in reducing the switching current and voltage. This kind of perpendicular anisotropy is seen in thin (0.5 to 3 nm thick) CoFeB layers in contact with MgO. The switching speed and free layer precession frequency depends on the free layer perpendicular anisotropy. Larger perpendicular anisotropy leads to lower frequency precession, reducing the switching speed. Third, the damping parameter of the free layer can be reduced to reduce the switching current and voltage. This and other means may be used to reduce the switching voltage and current threshold.

The foregoing description of embodiments of the present invention has been presented for purposes of illustration and description. It is not intended to be exhaustive or to limit the present invention to the precise form disclosed, and modifications and variations are possible in light of the above teachings or may be acquired from practice of the present invention. The embodiments were chosen and described in order to explain the principles of the present invention and its practical application to enable one skilled in the art to utilize the present invention in various embodiments, and with various modifications, as are suited to the particular use contemplated.

**Claims**

1. A magnetic device comprising:

   a polarizing layer (P) magnetized perpendicular to a free magnetic layer (FL), wherein the polarizing layer (P) comprises a Co/Ni multilayer or a Co/Pt multilayer that reduces the spin polarization of the polarizing layer (P);
   the free magnetic layer (FL) forming a first electrode and separated from the magnetized polarizing layer (P) by a first non-magnetic metal layer, the free magnetic layer (FL) having a magnetization vector having at least a first stable state and a second stable state;
   a reference layer (SAF) forming a second electrode and separated from the free-magnetic layer by a second non-magnetic layer, the reference layer (SAF) having a fixed magnetization vector;
   wherein the magnetization vector of the free magnetic layer is set via application of a unipolar current pulse, having either positive or negative polarity and a selected amplitude and duration, through the magnetic device that bipolarly switches the magnetization vector from the first stable state to the second stable state or the second stable state to the first stable state, wherein the unipolar current pulse is orthogonal to the polarizing layer (P).

2. The magnetic device as defined in Claim 1 wherein spin transfer torques associated with the polarizing layer (P) and an in-plane magnetized form of the reference layer (SAF) can be described by,

$$\frac{d\hat{m}}{dt} = -\gamma\mu_0\hat{m} \times \vec{H}_{\text{eff}} + \alpha\hat{m} \times \frac{d\hat{m}}{dt} + \gamma a_J\hat{m} \times (\hat{m} \times \hat{m}_P) - \beta\gamma a_J\hat{m} \times (\hat{m} \times \hat{m}_R)$$

where $m$ represents the magnetization direction of the free layer magnetization, $a_J$ is a term proportional to current of the unipolar current pulse and spin-polarization of the unipolar current pulse, the third term on the right hand side of this equation being spin transfer torque from the polarizing layer ($m_p$) and the fourth term on the right hand side of the equation being a spin transfer torque from an in-plane magnetized form of the reference layer ($m_R$), and $\beta$ represents a ratio of magnitude of these spin transfer torques.

3. The magnetic device as defined in Claim 2 wherein $\beta > 1$ provides a range of current pulse amplitudes wherein switching of the magnetic device is directly from parallel to anti- parallel for a first current polarity and anti-parallel to parallel for a second current polarity.

4. The magnetic device as defined in Claim 2 wherein switching of the magnetization vector of the free magnetic layer (FL) is precessional and bipolar for both polarities.

5. The magnetic device as defined in Claim 2 wherein $\beta$ less than or equal to 1 provides at least one of reduced direct current switching errors and precessional and fast switching.

6. The magnetic device as defined in Claim 2 wherein the magnetization direction becomes precessional for $\beta$ less than 1 , thereby providing higher precession frequencies for higher current amplitudes.

7. The magnetic device as defined in Claim 2 wherein $\beta$ is selected from the group of 1 or greater than 1 and pulse polarity and amplitude of the current pulse controls a final magnetization state of the free magnetic layer (FL) and independent of the current pulse duration.

8. The magnetic device as defined in Claim 7 wherein:-

   (i) spin polarization of the reference layer (SAF) is increased by selecting mating materials for the reference layer (SAF) and a magnetic tunnel junction layer adjacent thereto, and optionally or preferably
   (ii) wherein the mating materials are selected from the group of (a) CoFeB and MgO, (b) NiFe and MgO, and (c) CoFe and MgO.

9. The magnetic device as defined in Claim 7 wherein spin polarization from the polarizing layer (P) is reduced by further including a nonmagnetic layer disposed between the polarizing layer (P) and the free magnetic layer (FL), thereby controlling the spin polarization of carriers from the polarizing layer (P).

10. The magnetic device as defined in Claim 9:-

    (i) wherein the nonmagnetic layer comprises Cu with controlled defects, thereby reducing the spin polarization, or
    (ii) wherein the nonmagnetic layer can have varying layer thickness, thereby reducing spin polarization from the polarizing layer incident on the free magnetic layer.

11. A memory array comprising:

    at least one bit cell including:

       a magnetic device having:

          a free magnetic layer (FL) having a variable magnetization vector having at least a first stable state and a second stable state;
          a polarizing layer (P) having a fixed magnetization vector perpendicular to the free magnetic layer, wherein the polarizing layer comprises a Co/Ni multilayer or a Co/Pt multilayer that reduces the spin polarization of the polarizing layer;
          a non-magnetic layer separating the magnetic layer with fixed magnetization vector and the free magnetic layer;

wherein the variable magnetization vector of the free magnetic layer is set via application of a

unipolar current pulse having either positive or negative polarity and a sufficient amplitude and duration through the magnetic device bipolarly switches the magnetization vector from either the first stable state to the second stable state or from the second stable state to the first stable state,
wherein the unipolar current pulse is orthogonal to the polarizing layer; and
at least one transistor for current control and readout wherein application of a voltage to the at least one bit cell activates the bit cell.

**Patentansprüche**

1. Eine Magnetvorrichtung, die Folgendes aufweist:

   eine Polarisierungsschicht (P), die im rechten Winkel auf eine freie Magnetschicht (FL) magnetisiert wird, wobei die Polarisierungsschicht (P) eine Co/Ni-Multischicht oder eine Co/Pt-Multischicht aufweist, die die Spinpolarisation der Polarisierungsschicht (P) reduziert;
   die freie Magnetschicht (FL) bildet dabei eine erste Elektrode und ist getrennt von der magnetisierten Polarisierungsschicht (P) durch eine erste nichtmagnetische Metallschicht, die freie Magnetschicht (FL) hat dabei einen Magnetisierungsvektor mit mindestens einem ersten stabilen Zustand und einem zweiten stabilen Zustand;
   eine Referenzschicht (SAF) bildet eine zweite Elektrode und ist getrennt von der freien Magnetschicht durch eine zweite Nicht-Magnetschicht, wobei die Referenzschicht (SAF) einen festen Magnetisierungsvektor hat;
   wobei der Magnetisierungsvektor der freien Magnetschicht über die Anwendung eines unipolaren Stromimpulses festgelegt wird, entweder mit positiver oder negativer Polarität und einer ausgewählten Amplitude und Dauer, durch die Magnetvorrichtung, die den Magnetisierungsvektor bipolar vom ersten stabilen Zustand zum zweiten stabilen Zustand oder den zweiten stabilen Zustand zum ersten stabilen Zustand umschaltet, wobei der unipolare Stromimpuls orthogonal zur Polarisierungsschicht (P) ist.

2. Die Magnetvorrichtung wie in Anspruch 1 definiert, wobei die Spintransfer-Drehmomente, die mit der Polarisierungsschicht (P) verbunden sind, und die auf gleicher Ebene magnetisierte Form der Referenzschicht (SAF) durch Folgendes beschrieben werden können,

$$\frac{d\hat{m}}{dt} = -\gamma\mu_0\hat{m}\times\vec{H}_{\text{eff}} + \alpha\hat{m}\times\frac{d\hat{m}}{dt} + \gamma a_J\hat{m}\times(\hat{m}\times\hat{m}_P) - \beta\gamma a_J\hat{m}\times(\hat{m}\times\hat{m}_R)$$

   wobei m die Magnetisierungsrichtung der freien Schicht-Magnetisierung repräsentiert, $\alpha_J$ eine Größe proportional zum Strom des unipolaren Stromimpulses und Spinpolarisierung des unipolaren Stromimpulses ist, die dritte Größe auf der rechten Seite dieser Gleichung ein Spintransfer-Drehmoment von der Polarisierungsschicht ($m_P$) ist und die vierte Größe auf der rechten Seite dieser Gleichung ein Spin-Transfer-Drehmoment von einer auf gleicher Ebene magnetisierten Form der Referenzschicht ($m_R$) ist, und $\beta$ ein Größenverhältnis dieser Spintransfer-Drehmomente repräsentiert.

3. Die Magnetvorrichtung wie in Anspruch 2 definiert, wobei $\beta > 1$ einen Bereich von Stromimpulsamplituden bietet, wobei die Magnetvorrichtung direkt von parallel zu antiparallel für eine erste Strompolarität und von antiparallel zu parallel für eine zweite Strompolarität umgeschaltet wird.

4. Die Magnetvorrichtung wie in Anspruch 2 definiert, wobei der Magnetisierungsvektor der freien Magnetschicht (FL) für beide Polaritäten präzessional und bipolar ist.

5. Die Magnetvorrichtung wie in Anspruch 2 definiert, wobei $\beta$ weniger oder gleich 1 mindestens entweder reduzierte direkte Stromumschaltungs-Fehler oder Präzessions- oder Schnellumschaltung bietet.

6. Die Magnetvorrichtung wie in Anspruch 2 definiert, wobei die Magnetisierungsrichtung für $\beta$ weniger als 1 präzessional wird, wodurch höhere Präzessionsfrequenzen für höhere Stromamplituden erreicht werden.

**7.** Die Magnetvorrichtung wie in Anspruch 2 definiert, wobei β ausgewählt ist aus der Gruppe von 1 oder größer als 1, und die Impulspolarität und -amplitude des Stromimpulses einen endgültigen Magnetisierungszustand der freien Magnetschicht (FL) und unabhängig von der Stromimpulsdauer steuert.

**8.** Die Magnetvorrichtung wie in Anspruch 7 definiert, wobei:-

(i) die Spinpolarisation der Referenzschicht (SAF) durch Auswahl von Werkstoffpaarungen für die Referenzschicht (SAF) und einer daran angrenzenden Tunnelübergangs-Magnetschicht erhöht wird und, optional oder vorzugsweise,
(ii) wobei die Werkstoffpaarungen ausgewählt sind aus der Gruppe von (a) CoFeB und MgO, (b) NiFe und MgO und (c) CoFe und MgO.

**9.** Die Magnetvorrichtung wie in Anspruch 7 definiert, wobei die Spinpolarisation von der Polarisierungsschicht (P) weiter reduziert wird durch die Einfügung einer nichtmagnetischen Schicht, die zwischen der Polarisierungsschicht (P) und der freien Magnetschicht (FL) aufgebracht ist, wodurch die Spinpolarisation der Träger von der Polarisierungsschicht (P) gesteuert wird.

**10.** Die Magnetvorrichtung wie in Anspruch 9 definiert:-

(i) wobei die nichtmagnetische Schicht ein Cu mit gesteuerten Mängeln aufweist, wodurch die Spinpolarisation reduziert wird, oder
(ii) wobei die Nicht-Magnetschicht variierende Schichtdicken haben kann, wodurch die Spinpolarisation vom Polarisierungsschicht-Ereignis auf der freien Magnetschicht reduziert wird.

**11.** Eine Speichermatrix, die Folgendes aufweist:

mindestens eine Bitzelle, einschließlich:

einer Magnetvorrichtung mit:

einer freien Magnetschicht (FL) mit einem variablen Magnetisierungsvektor mit mindestens einem ersten stabilen Zustand und einem zweiten stabilen Zustand;
eine Polarisierungsschicht (P) mit einem festen Magnetisierungsvektor, der im rechten Winkel zu einer freien Magnetschicht (FL) ist, wobei die Polarisierungsschicht eine Co/Ni-Multischicht oder eine Co/Pt-Multischicht aufweist, die die Spinpolarisation der Polarisierungsschicht reduziert;
einer nichtmagnetischen Schicht, die die Magnetschicht mit festem Magnetisierungsvektor und die freie Magnetschicht trennt;

wobei der variable Magnetisierungsvektor der freien Magnetschicht über die Anwendung eines unipolaren Stromimpulses festgelegt wird, entweder mit positiver oder negativer Polarität und einer ausreichenden Amplitude und Dauer, durch die Magnetvorrichtung, die den Magnetisierungsvektor bipolar entweder vom ersten stabilen Zustand zum zweiten stabilen Zustand oder den zweiten stabilen Zustand zum ersten stabilen Zustand umschaltet, wobei der unipolare Stromimpuls orthogonal zur Polarisierungsschicht (P) ist; und
mindestens einem Transistor für die Stromregelung und -anzeige, wobei die Anwendung einer Stromspannung auf die mindestens eine Bitzelle die Bitzelle aktiviert.

**Revendications**

**1.** Dispositif magnétique comprenant :

une couche polarisante (P) magnétisée perpendiculairement à une couche magnétique libre (FL), laquelle couche polarisante (P) comprenant une multicouche de Co/Ni ou une multicouche de Co/Pt qui réduit la polarisation de spin de la couche polarisante (P) ;
la couche magnétique libre (FL) formant une première électrode et étant séparée de la couche polarisante magnétisée (P) par une première couche métallique non magnétique, la couche magnétique libre (FL) présentant un vecteur de magnétisation ayant au moins un premier état stable et un second état stable ;

une couche de référence (SAF) formant une seconde électrode et séparée de la couche magnétique libre par une seconde couche non magnétique, la couche de référence (SAF) présentant un vecteur de magnétisation fixe ;

dans lequel le vecteur de magnétisation de la couche magnétique libre est établi via l'application d'une impulsion à courant unipolaire ayant une polarité soit positive, soit négative et une amplitude et une durée sélectionnées dans le dispositif magnétique qui commute de manière bipolaire le vecteur de magnétisation du premier état stable vers le second état stable ou du second état stable vers le premier état stable, et dans lequel l'impulsion de courant unipolaire est orthogonale à la couche polarisante (P).

2. Dispositif magnétique selon la revendication 1, dans lequel les couples de transfert de spin associés à la couche polarisante (P) et la forme magnétisée dans le plan de la couche de référence (SAF) peuvent être décrits par

$$\frac{d\hat{m}}{dt} = -\gamma\mu_0\hat{m} \times \vec{H}_{\text{eff}} + \alpha\hat{m} \times \frac{d\hat{m}}{dt} + \gamma a_J\hat{m} \times (\hat{m} \times \hat{m}_P) - \beta\gamma a_J\hat{m} \times (\hat{m} \times \hat{m}_R)$$

où m représente le sens de magnétisation de la magnétisation de la couche libre, $\alpha_J$ est un terme proportionnel au courant de l'impulsion de courant unipolaire et à la polarisation de spin de l'impulsion de courant unipolaire, le troisième terme du côté droit de cette équation est le couple de transfert de spin depuis la couche polarisante ($m_P$) et le quatrième terme de la droite de l'équation est un couple de transfert de spin depuis une forme magnétisée dans le plan de la couche de référence ($m_R$), et β représente un ratio d'amplitude de ces couples de transfert de spin.

3. Dispositif magnétique selon la revendication 2, dans lequel β > 1 procure une plage d'amplitude d'impulsions de courant, dans lequel la commutation du dispositif magnétique se fait directement de parallèle à antiparallèle pour une première polarité de courant et d'antiparallèle à parallèle pour une seconde polarité de courant.

4. Dispositif magnétique selon la revendication 2, dans lequel la commutation du vecteur de magnétisation de la couche magnétique libre (FL) est précessionnelle et bipolaire pour les deux polarités.

5. Dispositif magnétique selon la revendication 2, dans lequel β inférieur ou égal à 1 est source d'au moins un effet sur des erreurs réduites de commutation de courant direct et de commutation précessionnelle et rapide.

6. Dispositif magnétique selon la revendication 2, dans lequel le sens de magnétisation devient précessionnel pour β inférieur à 1, en assurant ainsi des fréquences de précession plus élevées pour des amplitudes de courant plus élevées.

7. Dispositif magnétique selon la revendication 2, dans lequel β est sélectionné dans le groupe de 1 ou supérieur à 1 et la polarité d'impulsion et l'amplitude de l'impulsion de courant commandent un état final de magnétisation de la couche magnétique libre (FL) indépendant de la durée de l'impulsion de courant.

8. Dispositif magnétique selon la revendication 7, dans lequel :-

    (i) la polarisation de spin de la couche de référence (SAF) est augmentée en sélectionnant des matières adaptées pour la couche de référence (SAF) et une couche de jonction de tunnel magnétique qui lui est adjacente et, en option ou de référence,
    (ii) dans lequel les matières adaptées sont sélectionnées dans le groupe composé de (a) CoFeB et MgO, (b) NiFe et MgO, et (c) CoFe et MgO.

9. Dispositif magnétique selon la revendication 7, dans lequel la polarisation de spin depuis la couche polarisante (P) est réduite en incluant en outre une couche non magnétique disposée entre la couche polarisante (P) et la couche magnétique libre (FL), en commandant ainsi la polarisation de spin des supports depuis la couche polarisante (P).

10. Dispositif magnétique selon la revendication 9,

    (i) dans lequel la couche non magnétique comprend du Cu à défauts contrôlés, ce qui réduit la polarisation de spin ou

(ii) dans lequel la couche non magnétique peut avoir une épaisseur de couche variable, ce qui réduit la polarisation de spin depuis la couche polarisante incidente sur la couche magnétique libre.

11. Matrice de mémoire comprenant :

au moins une cellule de bit incluant :

un dispositif magnétique présentant :

une couche magnétique libre (FL) présentant un vecteur de magnétisation variable ayant au moins un premier état stable et un second état stable ;
une couche polarisante (P) présentant un vecteur de magnétisation fixe perpendiculaire à la couche magnétique libre, dans laquelle la couche polarisante comprend une multicouche de Co/Ni ou une multicouche de Co/Pt qui réduit la polarisation de spin de la couche polarisante ;
une couche non magnétique séparant la couche magnétique à vecteur de magnétisation fixe et la couche magnétique libre ;

dans laquelle le vecteur de magnétisation variable de la couche magnétique libre est établi via l'application d'une impulsion de courant unipolaire ayant une polarité soit positive, soit négative et une amplitude et une durée suffisantes dans le dispositif magnétique qui commute de manière bipolaire le vecteur de magnétisation soit du premier état stable vers le second état stable, soit du second état stable vers le premier état stable et dans laquelle l'impulsion de courant unipolaire est orthogonale à la couche polarisante ; et
au moins un transistor pour la commande et la consultation du courant et dans laquelle l'application d'une tension à l'au moins une cellule de bit active la cellule de bit.

FIG. 1(a)

FIG. 1(b)

FIG. 1(c)

IN PLANE        OUT OF PLANE

FIG. 2

FIG. 3

FIG. 4(a)

FIG. 4(b)

FIG. 5

FIG. 6(a)

FIG. 6(d)

FIG. 6(b)

FIG. 6(e)

FIG. 6(c)

FIG. 6(f)

FIG. 7(a)

FIG. 7(b)

FIG. 7(c)

EP 2 641 247 B1

FIG. 8(a)

FIG. 8(b)

FIG. 8(c)

X COMPONENT

FIG. 9(a)

TIME (ns)

Y COMPONENT

FIG. 9(b)

TIME (ns)

Z COMPONENT

FIG. 9(c)

TIME (ns)

FIG. 10(a)

FIG. 10(b)

FIG. 10(c)

X COMPONENT

FIG. 11(a)

Y COMPONENT

FIG. 11(b)

Z COMPONENT

FIG. 11(c)

FIG. 12(a)

FIG. 12(b)

FIG. 12(c)

X COMPONENT

FIG. 13(a)

TIME (ns)

Y COMPONENT

FIG. 13(b)

TIME (ns)

Z COMPONENT

FIG. 13(c)

TIME (ns)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 61414724 A
- US 04110411 A
- US 49058809 A
- US 93274507 A
- US 49830306 A
- US 25079105 A
- US 7170778 B
- US 64376203 A
- US 6980469 B
- US 5695864 A
- US 20100195380 A
- US 20090296462 A
- US 20060092696 A

**Non-patent literature cited in the description**

- **R. H. KOCH et al.** *Phys. Rev. Lett.,* 2000, vol. 84, 5419
- **J. SLONCKEWSKI.** *Journal of Magnetism and Magnetic Materials,* 1996, vol. 159, LI